# EUROPEAN PATENT SPECIFICATION

(11) **EP 3 999 992 B1**
(45) Date of publication and mention of the grant of the patent: **12.02.2025**
(21) Application number: 19778872.2
(22) Date of filing: 17.09.2019
(51) Int. Cl.: G06F 30/20

(54) **A METHOD FOR COMPUTER-IMPLEMENTED GENERATION OF A STATE MACHINE FROM A SIMULATED TECHNICAL COMPONENT IN A BLOCK-BASED SIMULATION MODEL**
VERFAHREN ZUR COMPUTERIMPLEMENTIERTEN GENERIERUNG EINER ZUSTANDSMASCHINE AUS EINER SIMULIERTEN TECHNISCHEN KOMPONENTE IN EINEM BLOCKBASIERTEN SIMULATIONSMODELL
PROCÉDÉ POUR LA GÉNÉRATION MISE EN OEUVRE PAR ORDINATEUR D'UN AUTOMATE FINI À PARTIR D'UN COMPOSANT TECHNIQUE SIMULÉ DANS UN MODÈLE DE SIMULATION À BASE DE BLOCS

(43) Date of publication of application: 25.05.2022
(73) Proprietor: Siemens Aktiengesellschaft, 80333 München (DE)
(72) Inventor: WITTE, Martin, 91126 Schwabach (DE)
(74) Representative: Siemens Patent Attorneys
(86) International application number: PCT/EP2019/074868
(87) International publication number: WO 2021/052569

(56) References cited:
- H. FU ET AL: "Hybrid automata of an integrated motor-transmission powertrain for automatic gear shift", 2011 AMERICAN CONTROL CONFERENCE (ACC), 2011, pages 4604 - 4609, XP055701308, ISSN: 0743-1619, DOI: 10.1109/ACC.2011.5991137

## Description

The invention refers to a method and an apparatus for computer-implemented generation of a state machine from a simulated technical component in a block-based simulation model. Furthermore, the invention refers to a corresponding computer program product and a corresponding computer program.

Block-based simulation models are known from the prior art. Those models enable simulations of a corresponding technical component being modelled by the simulation model. The technical component being simulated by the simulation model is described by a block within the simulation model where the block can be coupled to other blocks referring to other simulated technical components. In the following, the term technical component is to be interpreted broadly and may refer to components of arbitrary size which may also have sub-components. E.g., a technical component may be a technical system comprising a plurality of sub-components.

The behaviour of technical components may also be described based on automatons which are also referred as to state machines. Automatons for technical components represent the states of the technical components and transitions between those states. The description of a technical component by an automaton enables to apply specific analysis methods. Particularly, the behaviour of a technical component described by an automaton can be formally verified. This is particularly useful in order to verify sequences of actions based on skills of the technical component described by the automaton.

Up to now, there do not exist any mechanisms enabling to convert a simulated technical component described by a simulation model into an automaton by the use of a computer.

Hence, it is an object of the invention to provide a computer-implemented method for generating a state machine (i.e. an automaton) from a simulated technical component in a block-based simulation model.

This object is solved by the independent patent claims. Preferred embodiments of the invention are defined in the dependent claims.

The method of the invention enables a computer-implemented generation of a state machine from a simulated technical component in a block-based simulation model, where the simulated technical component is a block in the simulation model and comprises a number of variables. Each variable has a value range with variable values which can be assigned to the respective variable when running a simulation of the technical component based on the simulation model. Preferably, the variables refer to continuous variables having a continuous variable range. Nevertheless, one or more of the variables may also refer to variables assuming discrete values. The simulated technical component may refer to any technical component, e.g. a component in an industrial automation system and/or an electric motor.

In the method of the invention, the following steps a) to e) are performed. In step a), one or more variables from the plurality of variables are selected. This can be performed automatically or semi-automatically as will be described later on.

In step b), a plurality of discrete states is generated for each selected variable, each state comprising a subset of values from the value range of the respective selected variable. In case that the selected variables have continuous value ranges, regions within the respective value ranges are defined which are associated with corresponding discrete states. In the same way, one or more discrete variable values may be associated with discrete states in case that the variable has discrete values. The discretization according to step b) is needed in order to generate automatons describing state changes as will be described in the following.

In step c), an automaton is generated for each selected variable, a respective automaton being represented by the states as generated in step b) of the respective selected variable and by one or more transitions from one state to another state of the respective variable. A respective transition is referenced by a label and it is associated with a trigger condition defining the change of the respective selected variable resulting in the respective transition. In other words, the trigger condition defines that the respective transition is triggered when the value of the respective selected variable changes such that this change corresponds to a change between states as represented by the respective transition.

In step d), a first product automaton is generated from the automatons of all selected variables. This first product automaton comprises a plurality of vector states representing all combination of states of all selected variables and a plurality of vector transitions for all transitions of single variables generated in step c). I.e., each vector transition corresponds to a transition from one state to another state of a single variable as defined in step c) in a respective vector state where the states of the other variables in the respective vector state remain unchanged. In this first product automaton, the label and the trigger condition of the respective vector transition correspond to the label and trigger condition of the transition to which the respective vector transition corresponds.

In step e), superfluous vector transitions are removed from the first product automaton generated in step d). This removal is based on predefined rules applying to the simulation model. Particularly, those predefined rules describe the physics and/or the logic underlying the behaviour of the simulated technical component. The removal of superfluous vector transitions results in a second product automaton which is the first product automaton not containing the removed superfluous vector transitions. This second product automaton is the state machine generated by the method of the invention. Due to the removal of superfluous vector transitions, the product automaton is reduced in size so that less computational recourses are needed when processing the product automaton.

The method according to the invention enables a computer-implemented generation of an automaton based on a simulation model for a technical component. This is achieved by an adequate discretization of variables in the technical component and by creating a product automaton based on discrete states for the technical system. As a consequence, the simulated technical component may be subjected to methods which process automatons. E.g., the automaton generated by the method of the invention may be used in implementations based on control theory.

In a preferred embodiment of the invention, step a) is performed at least partly automatically based on a predefined selection of at least one variable. I.e., the variables important for the behaviour of the generated state machine are defined in advance. Alternatively or additionally, step a) is performed at least partly semi-automatically in response to user inputs via a user interface, the user inputs specifying at least one variable which is to be selected.

In another preferred embodiment of the invention, step b) is performed at least partly automatically based on predefined subsets of values from the value range of one or more selected variables. Alternatively or additionally, step b) is performed at least partly semi-automatically in response to one or more user inputs via a user interface defining subsets of values from the value range of one or more selected variables.

Analogously to step a) and step b), step c) may also be performed at least partly automatically for at least one selected variable in order to generate an automaton for the at least one selected variable. E.g., this automatic generation of an automaton may be performed in case that the respective variable has values with an order defining an adjacency relation. This is e.g. the case when the variable refers to numbers. For variables having an order, transitions between adjacent regions of values corresponding to states may be defined up and down the ordering.

Additionally or alternatively, step c) may also be performed at least partly semi-automatically in response to one or more user inputs via a user interface for at least one selected variable in order to generate an automaton for the at least one selected variable, the one or more user inputs specifying the transitions of the at least one selected variable. This semi-automatic generation of an automaton is preferably used for variables with non-ordered values.

In another preferred embodiment, a validation step is automatically performed between step d) and step e), where the validation step tests whether the first product automaton generates outputs corresponding to outputs of the simulation model when running a simulation of the technical component based on the simulation model, where the method proceeds with step e) in case of a successful validation and where otherwise (i.e. in case of a failed validation) the method provides an input option on a user interface enabling one or more user inputs to modify the first product automaton, whereupon step d) is repeated based on the modified first product automaton.

Here and in the following, a successful validation refers to the scenario that the outputs of the simulation model correspond to the outputs of the product automaton whereas a failed validation refers to the scenario that at least one output of the simulation product does not correspond to the corresponding output of the product automaton. In the above validation step, the product automaton is the first product automaton. In the validation steps as defined later on, the product automaton is a second product automaton or a third product automaton. The above validation step and also the validation steps described later on enable a test whether the product automaton corresponds to the simulated technical component in the simulation model. If not, means for modifying the automaton by a user are provided.

In another preferred embodiment, a validation step is automatically performed after step e), where the validation step tests whether the second product automaton generates outputs corresponding to outputs of the simulation model when running a simulation of the technical component based on the simulation model, where the method either terminates or proceeds with another step without enabling a manual modification of the second product automaton in case of a successful validation. Otherwise, i.e. in case of a failed validation, the method provides an input option on a user interface enabling one or more user inputs to modify the second product automaton, whereupon step e) is repeated based on the modified second product automaton.

In another preferred embodiment, the second product automaton is further processed after step e) by a step f) comprising one or more merging operations, where in a respective merging operation several vector states of the second product automaton differing in the value of a single variable are merged to a common vector state substituting the merged vector states, the vector transitions referring to the merged vector states being adapted to vector transitions referring to the common vector state, thus resulting in a third product automaton. This step has the advantage that the size of the second product automaton is reduced.

Depending on the circumstances, at least one merging operation is performed automatically based on predefined rules and/or at least one merging operation is performed semi-automatically in response to one or more user inputs via user interface, the one or more user inputs specifying the vector states to be merged.

In a particularly preferred embodiment, the vector transitions of the merged vector states are adapted to vector transitions referring to the common state as follows:
i) in case that a vector transition refers to a vector transition from one merged vector state to another merged vector state, a self-loop transition is generated from the common vector state to the common vector state having a new label and the same trigger condition as the vector transition from the merged vector state to the other merged vector state;
ii) in case that there are several vector transitions from a non-merged vector state to different merged vector states, a single vector transition having a new label is generated, the trigger condition being an OR concatenation of the trigger conditions of the said several vector transitions;
iii) in case that there are several vector transitions from different merged vector states to different non-merged vector states being referenced by the same label and trigger condition, each of said several vector transitions receives a different label and a trigger condition discriminating between different merged vector states.

In another embodiment of the invention, a validation step is automatically performed after the above step f)**,** where the validation step tests whether the third product automaton generates outputs corresponding to outputs of the simulation model when running a simulation of the technical component based on the simulation model, where the method terminates in case of a successful validation and where otherwise (in case of a failed validation) the method provides an input option on a user interface enabling one or more user inputs to modify the third product automaton, whereupon step f) is repeated based on a modified second product automaton.

Besides the above method, the invention refers to an apparatus which is adapted to perform the computer-implemented method of the invention or one or more preferred embodiments of this method. In other words, the apparatus comprises one or more processors providing means for performing steps a) to e) according to the invention and optionally for performing the steps of preferred embodiments of the invention.

Furthermore, the invention refers to a computer program product with program code, which is stored on a non-transitory machine-readable carrier, for carrying out the method according to the invention or one or more preferred embodiments thereof when the program code is executed on a computer.

Moreover, the invention refers to a computer program with program code for carrying out the method according to the invention or one or more preferred embodiments thereof when the program code is executed on a computer.

In the following, embodiments of the invention will be described in detail with respect to the accompanying drawings, wherein
- Fig. 1: shows a simulated technical component based on which a variant of the invention will be described;
- Fig. 2: is a flowchart illustrating the steps of an embodiment of the invention;
- Fig. 3: is an illustration of the automatons generated in step S3 of Fig. 2;
- Fig. 4: is an illustration of the first product automaton generated in step S4 of Fig. 2;
- Fig. 5: is an illustration of the second product automaton generated in step S5 of Fig. 2; and
- Fig. 6: is an illustration of the third product automaton generated in step S6 of Fig. 2.

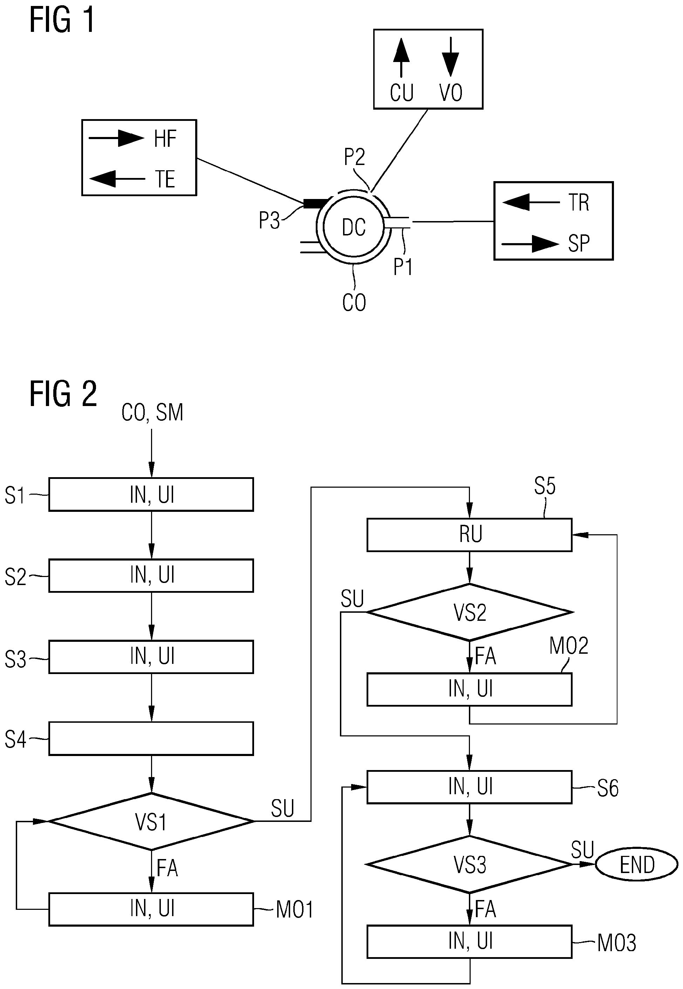

In the following, an embodiment of the invention will be described with respect to the simulated technical component CO shown in Fig. 1. This component is an electric motor in a block-based simulation model and forms a corresponding block in this model. The block-based simulation model is the known Amesim model for DC motors. Nevertheless, another known simulation model for simulating such a motor or another technical component may be used for implementing the invention, e.g. the simulation models SysML or Simulink.

The operation of the motor in Fig. 1 during a simulation by the Amesim model is described by values of variables at respective ports P1, P2 and P3. Port P1 provides the variable speed SP and the variable torque TR. The speed refers to the rotation speed of the motor CO whereas the torque refers to the torque provided by the motor. Port P2 provides the variable current CU and voltage VO referring to the electric current and voltage in the DC motor. Port P3 provides the heat flow rate HF and the temperature TE referring to the heat flow rate occurring in the motor and the temperature of the motor.

As indicated in Fig. 2, the simulation model SM simulating the motor CO is used as an input for the method as described in the following. The method of Fig. 2 converts the motor described by the simulation model SM in a state machine having the same behavior as the motor in the simulation model. This state machine (also designated as automaton) may thereafter be used for different purposes, e.g. for implementations in control theory or other fields where automatons are typically used.

In step S1 of Fig. 2, some variables of the variables SP, TR, CU, VO, HF and TC are selected. Those variables are relevant for aspects modelled in the state machine. The selection may be predefined. Additionally or alternatively, some selected variables may be defined based on inputs IN on a user interface UI. In other words, the selection is based on user inputs IN processed in the method of the Fig. 1.

In the embodiment described herein, the three variables SP, TR and VO are selected as the relevant variables. Each of the selected variables SP, TR and VO is characterized by a continuous value range of values which can be assumed by the respective variable. However, in order to use those variables for state machines, discrete states of those variables need to be generated. This discretization is performed in step S2 of Fig. 1.

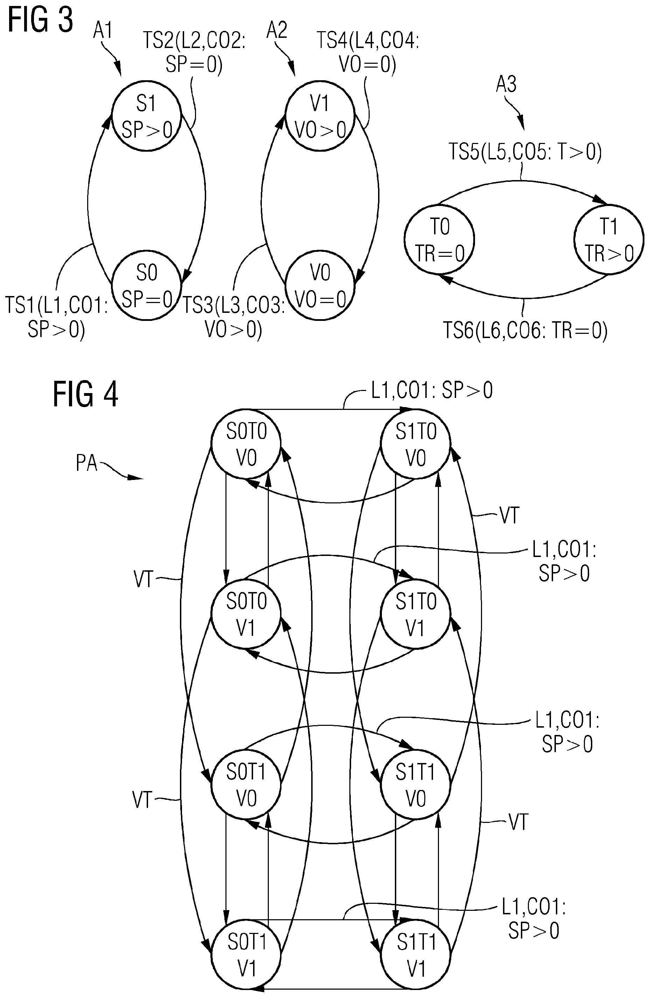

In step S2, each variable is divided in two regions, namely a region, where the variable has the value 0, and the region, where the variable has a value greater than 0. Each region forms a respective state. For the variable speed SP, a speed equal to 0 is indicated as state S0 (SP = 0) whereas a state of a speed greater than 0 is indicated as state S1 (SP > 0). For the variable torque TR, a state of zero torque is indicated as state T0 (TR = 0) whereas a state of torque greater than 0 is indicated as state T1 (TR > 0). For the variable voltage VO, a state with zero voltage is indicated as state V0 (VO = 0) whereas a state with a voltage greater than 0 is indicated as state V1 (VO > 0). The above states are shown in Figs. 3 to 6 which will be described later on.

As a result of step S2, the above defined states S0, S1, V0, V1, T0 and T1 are provided for defining automatons in step S3, as will be described in the following. In step S3, an automaton A1 is generated for variable SP, an automation A2 for variable VO and an automaton A3 for variable TR. Those automatons are shown in Fig. 3. Each automaton is characterized by the states which can be assumed by the respective variable as well as possible transitions between the states which are indicated as arrows in Fig. 3.

As can be seen from Fig. 3, there are six transitions TS1 to TS6. Each transition is specified by a label and a trigger condition defining the change of the respective variable resulting in the transition. According to Fig. 3, the variable SP of automaton A1 has the transition TS1 from state S0 to S1 associated with label L1 and trigger condition CO1 defined by SP > 0. Furthermore, the variable SP has the transition TS2 from state S1 to S0 associated with label L2 and trigger condition CO2 defined by SP = 0. The variable VO of automaton A2 has the transition TS3 referring to the change from state V0 to state V1 and being associated with label L3 and trigger condition CO3 defined by VO > 0. Furthermore, variable VO has the transition TS4 referring to a change from state V1 to state V0 and being associated with label L4 and trigger condition CO4 defined by VO = 0. Moreover, the variable TR of automaton A3 has the transition TS5 from state T0 to state T1 being associated with label L5 and trigger condition CO5 defined by T > 0. Moreover, the variable TR has the transition TS6 from state T1 to state T0 being associated with label L6 and trigger condition CO6 defined by TR = 0.

In the embodiment described herein, the automatons are generated automatically. This is because there are ordered sets of state variables based on adjacent value regions of variables. Therefore, transitions between adjacent regions can be defined as corresponding state transitions. However, in case that variables have non-ordered regions, step S3 may also be performed semi-automatically. In this case, a graphical representation of the regions is generated on a user interface UI. Based on this graphical representation, a user can define respective transitions between regions by user inputs IN, resulting in the generation of corresponding automatons.

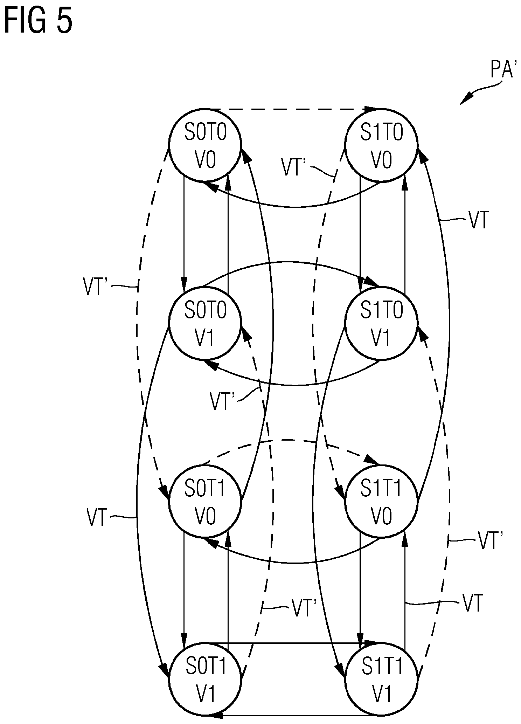

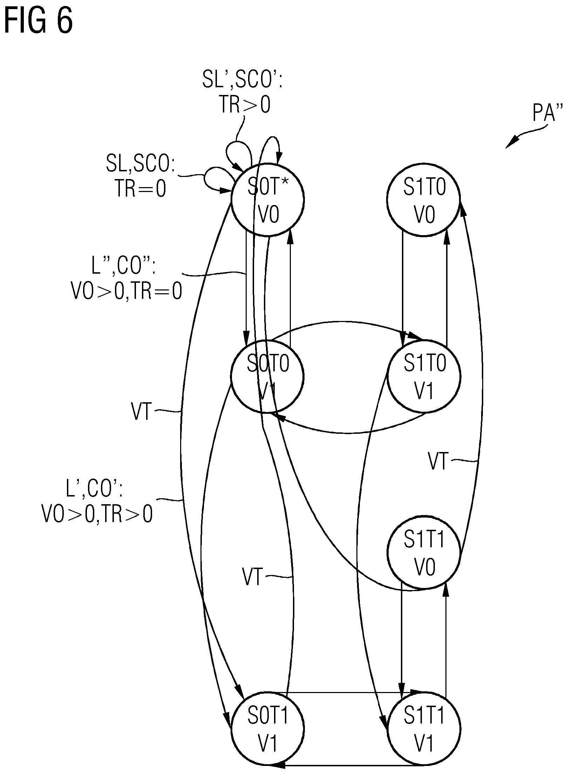

Based on the automatons A1, A2, A3 generated in step S3, a first product automaton is created in step S4 incorporating the labels and trigger conditions as defined for the single automatons A1 to A3. This first product automaton PA is shown in Fig. 4. The product automaton is based on vector states comprising the respective states of the three variables as well as vector transitions only referring to a state change of a single variable whereas the other variables are unchanged. The vector transitions in Fig. 4 and also in Figs. 5 and 6 are indicated by arrows VT (only partially designated by this reference numeral) between the vector states, i.e. combinations of states of the variables SP, TR and VO.

The respective vector transition VT receives the same label and trigger condition as the transition of the single variable within the respective automaton of Fig. 3. This is illustrated in Fig. 4 for vector transitions where the variable SP changes from the state S0 to state S1. In other words, the transition from vector state S0T0V0 to vector state S1T0V0, the transition from vector state S0T0V1 to vector state S1T0V1, the transition from vector state S0T1V0 to vector state S1T1V0 and the transition from vector state S0T1V1 to vector state S1T1V1 receive the label L1 and the trigger condition CO1 (SP > 0) as defined for automaton A1 in Fig. 3. In the same way, the other vector transitions in Fig. 4 are defined based on transitions on Fig. 3.

As shown in Fig. 2, the first product automaton PA generated by step S4 is thereafter subjected to a validation step VS1 where the validation step tests whether the first product automaton PA generates outputs corresponding to outputs of the simulation model SM when running a simulation of the motor CO based on the simulation model SM. In case that the validation step VS1 is successful (branch SU from validation step VS1), the method proceeds with step S5 described later on. In case that the validation step VS1 fails (branch FA from validation step VS1), the first product automaton PA can be modified in modification step MO1. This modification is done by a user based on user inputs IN on a user interface UI. After modification step MO1, the validation step VS1 is repeated for the modified product automaton. As mentioned above, a successful validation refers to the result that the outputs of the simulation model and the respective product automaton coincide whereas a failed validation occurs in case that at least one output of the simulation model differs from the corresponding output of the automaton.

After a successful validation step VS1, superfluous vector transitions in the first product automaton PA are removed in step S5 based on predefined rules RU applying to the simulation model SM. Those rules refer to the physical behavior of the motor CO in Fig. 1. The removal of superfluous vector transitions results in a second product automaton PO' shown in Fig. 4. The removed superfluous vector transitions are indicated by dashed arrows VT'. The removal of the vector transitions VT is based on the following physical laws reflected by the predefined rules RU:
- If the voltage is in the state V0, then a transition of the variable TR from T0 to T1 is impossible (no voltage no torque).
- If the voltage is in the state V0, then a transition of the variable SP from S0 to S1 is impossible (no voltage no speed).
- If the voltage is in the state V1, then a transition of the variable TR from T1 to T0 is impossible (if voltage and torque occurs, then the torque stays).

As shown in Fig. 2, the second product automaton PA' is subjected to another validation step VS2 in which it is tested whether the second product automaton PA' generates outputs corresponding to the outputs of the simulation model SM when running a simulation of the motor CO based on the simulation model SM. In case that the validation step VS2 fails (branch FA from step VS2), the second product automaton is modified in modification step MO2 based on user inputs IN on a user interface UI. Thereafter, step S5 is repeated based on the modified second product automaton.

In case that the validation step VS2 succeeds (branch SU from step VS2), the method proceeds with step S6. Step S6 and the subsequent validation and modification steps VS3 and MO3 are optional and the second product automaton generated in step S5 may be the result, i.e. the generated state machine, produced by the invention. This automaton shows the same behavior as the simulation model SM for the motor CO and may be used in various applications and particularly in control theory.

In step S6 of Fig. 2, several states of the second automaton PO' are merged. This merging may be done automatically, e.g. states with common regions of variables or region intersections may be combined to one single state. Alternatively or optionally, the merging may be performed semi-automatically where user inputs IN on a user interface UI specify the states which are to be merged. The merging of states has consequences with respect to the transitions originating or ending at a common vector state representing several merged states, resulting in an adaptation of those transitions. This will be described with respect to Fig. 6 showing a third automaton PA" resulting from the second automaton PA' of Fig. 5 by merging two states. In the scenario of Fig. 6, the vector states S0T0V0 and S0T1V0 shown in Fig. 5 are combined to the common vector state S0T*V0 because the torque is not of any interest in case of no speed and no voltage.

As a consequence, the transitions from merged state S0T0V0 to merged state S0T1V0 as well as from merged state S0T1V0 to merged state S0T0V0 need to be represented by new transitions in the form of self-loop transitions. Those self-loop transitions are indicated in Fig. 6 by two arrows starting from the common vector state S0T*V0 and also ending in this common vector state. Each of those self-loop transitions receives a different label and the trigger condition relevant for the original transition between the merged states. In other words, one self-loop transition has the label SL and the trigger condition SCO defined by TR = 0 (reflecting the transition from the merged state S0T1V0 to the merged state S0T0V0) whereas the other self-loop transition has the label SL' and the trigger condition SCO' defined by TR > 0 (reflecting the transition from the merged state S0T0V0 to the merged state S0T1V0).

Due to the generation of the common vector state S0T*V0, there are now two vector transitions originating from this common state to different non-merged states, namely to S0T0V1 and to S0T1V1. To make this non-deterministic behavior deterministic, different labels and trigger conditions are used for those transitions. In other words, the transition from the common vector state S0T*V0 to vector state S0T1V1 receives the label L' and the trigger condition CO' defined by VO > 0 and TR > 0. This corresponds to the vector transition of the state S0T1V0 to S0T1V1 of Fig. 5. Furthermore, the transition from the common vector state S0T*V0 to the non-merged vector state S0T0V1 is represented by a different label L" and the trigger condition CO" defined by VO > 0 and TR = 0. This corresponds to the vector transition from state S0T0V0 to the state S0T0V1 in Fig. 5.

After having conducted the merging as shown in Fig. 6, the third product automaton PA" resulting therefrom is once again subjected to a validation step VS3 shown in Fig. 2. In this validation step, it is tested whether the third product automaton PA" generates outputs corresponding to the outputs of the simulation model SM when running a simulation of the motor CO based on the simulation model SM. In case that this validation is successful (branch SU from step VS3), the method terminates with the successfully validated third product automaton. In case that the validation step VS3 fails (branch FA from step VS3), the third product automaton is modified in modification step MO3 based on user inputs IN on a user interface UI. After modification step MO3, the merging according to step S6 is repeated based on the modified third product automaton.

The invention as described in the foregoing has several advantageous. Particularly, an automaton is generated which relates automaton states to the state space of a block-based simulation model, making it possible to verify the state changes between simulation and automatons and interpret simulation changes as state changes of the automaton. The transitions in the automaton refer to physically possible state changes of the variables of the corresponding technical component. Trigger conditions for transitions have a physical interpretation in the state space. The ports and interfaces of the block-based simulation model can be mapped to transitions and labels of the automaton, allowing composition of automatons consistent with composition of simulation models. Due to the coupling of a simulation model with an automaton, automaton theories may be used for validation. Furthermore, automatons help to interpret simulation traces in terms of state changes of relevant system states without understanding the underlying simulation model. The automatons generated by the invention may be used for an automatic analysis of erroneous behavior and error recovery in simulated technical components, like machines and plants.

## Claims

1. A method for computer-implemented generation of a state machine from a simulated technical component (CO) in a block-based simulation model (SM), where the simulated technical component (CO) is a block in the simulation model (SM) and comprises a plurality of variables (SP, TR, CU, VO, HF, TE), each variable (SP, TR, CU, VO, HF, TE) having a value range with variable values which can be assigned to the respective variable (SP, TR, CU, VO, HF, TE) when running a simulation of the technical component (CO) based on the simulation model (SM), the method comprising the following steps:
a) selecting one or more variables (SP, TR, VO) from the plurality of variables (SP, TR, CU, VO, HF, TE);
b) generating for each selected variable (SP, TR, VO) a plurality of discrete states (S0, S1, V0, V1, T0, T1), each state (S0, S1, V0, V1, T0, T1) comprising a subset of values from the value range of the respective selected variable (SP, TR, VO);
c) generating an automaton (A1, A2, A3) for each selected variable (SP, VO, TR), a respective automaton (A1, A2, A3) being represented by the states (S0, S1, V0, V1, T0, T1) of the respective selected variable (SP, TR, VO) and one or more transitions (TS1, TS2, ..., TS6) from one state to another state of the respective selected variable (SP, TR, VO), a respective transition (TS1, TS2, ..., TS6) being referenced by a label (L1, L2, ..., L6) and being associated with a trigger condition (CO1, CO2, ..., CO6) defining the change of the respective selected variable (SP, TR, VO) resulting in the respective transition (TS1, TS2, ..., TS6);
d) generating a first product automaton (PA) from the automatons (A1, A2, A3) of all selected variables (SP, TR, VO), the first product automaton (PA) comprising a plurality of vector states (S0T0P0, S1T0V0, ..., S1T1V1) representing all combinations of states (S0, S1, V0, V1, T0, T1) of the selected variables (SP, VO, TR) and a plurality of vector transitions (VT) for all transitions (TS1, TS2, ..., TS6) of single variables (SP, TR, CU, VO, HF, TE) generated in step c), each vector transition (VT) corresponding to a transition (TS1, TS2, ..., TS6) from one state to another state of a single variable (SP, VO, TR) in a respective vector state (S0T0P0, S1T0V0, ..., S1T1V1) where the states (S0, S1, V0, V1, T0, T1) of the other variables (SP, VO, TR) in the respective vector state (S0T0P0, S1T0V0, ..., S1T1V1) remain unchanged, where the label (L1, L2, ..., L6) and the trigger condition (CO1, CO2, ..., CO6) of the respective vector transition (VT) correspond to the label (LA1, LA2, ..., LA6) and the trigger condition (CO1, CO2, ..., CO6) of the transition (TS1, TS2, ..., TS6) to which the respective vector transition (VT) corresponds;
e) removing superfluous vector transitions (VT') from the first product automaton (PA) based on predefined rules (RU) applying to the simulation model (SM), the first product automaton (PA) not containing the removed superfluous vector transitions (VT') is a second product automaton (PA') which is the generated state machine,
wherein said first product automaton (PA) is reduced in size such that less computational resources are needed when processing the second product automaton

2. The method according to claim 1, wherein step a) is performed at least partly automatically based on a predefined selection of at least one variable (SP, TR, VO) and/or wherein step a) is performed at least partly semi-automatically in response to one or more user inputs (IN) via a user interface (UI), the one or more user inputs (IN) specifying at least one variable (SP, TR, VO) which is to be selected.

3. The method according to claim 1 or 2, wherein step b) is performed at least partly automatically based on predefined subsets of values from the value range of one or more selected variables (SP, TR, VO) and/or wherein step b) is performed at least partly semi-automatically in response to user inputs (IN) via a user interface (UI) defining subsets of values from the value range of one or more selected variables (SP, TR, VO).

4. The method according to one of the preceding claims, wherein step c) is performed at least partly automatically for at least one selected variable in order to generate an automaton (A1, A2, A3) for the at least one selected variable (SP, VO, TR) and/or wherein step c) is performed at least partly semi-automatically in response to one or more user inputs (IN) via a user interface (UI) for at least one selected variable (SP, TR, VO) in order to generate an automaton (A1, A2, A3) for the at least one selected variable (SP, VO, TR), the one or more user inputs (IN) specifying the transitions (TS1, TS2, ..., TS6) of the at least one selected variable (SP, TR, VO).

5. The method according to one of the preceding claims, wherein a validation step (VS1) is automatically performed between steps d) and e), where the validation step (VS1) tests whether the first product automaton (PA) generates outputs corresponding to outputs of the simulation model (SM) when running a simulation of the technical component (CO) based on the simulation model (SM), where the method proceeds with step e) in case of a successful validation (VS1) and where otherwise the method provides an input option on a user interface (UI) enabling one or more user inputs (IN) to modify the first product automaton (PA), whereupon step d) is repeated based on the modified first product automaton (PA).

6. The method according to one of the preceding claims, wherein a validation step (VS2) is automatically performed after step e), where the validation step (VS2) tests whether the second product automaton (PA') generates outputs corresponding to outputs of the simulation model (SM) when running a simulation of the technical component (CO) based on the simulation model (SM), where the method terminates or proceeds with another step without enabling a manual modification of the second product automaton (PA') in case of a successful validation and where otherwise the method provides an input option on a user interface (UI) enabling one or more user inputs (IN) to modify the second product automaton (PA'), whereupon step e) is repeated based on the modified second product automaton (PA').

7. The method according to one of the preceding claims, wherein the second product automaton (PA') is further processed after step e) by a step f) comprising one or more merging operations, where in a respective merging operation several vector states (S0T0V0, S0T1V0) of the second product automaton (PA') differing in the value of a single variable (SP, TR, CU, VO, HF, TE) are merged to a common vector state (S0T*V0) substituting the merged vector states (S0T0V0, S0T1V0), the vector transitions (VT) referring to the merged vector states (S0T0V0, S0T1V0) being adapted to vector transitions referring to the common vector state, thus resulting in a third product automaton (PA").

8. The method according to claim 7, wherein at least one merging operation is performed automatically based on predefined rules and/or wherein at least one merging operation is performed semi-automatically in response to one or more user inputs (IN) via a user interface (UI), the one or more user inputs (IN) specifying the specifying the vector states (S0T0V0, S1T1V0) to be merged.

9. The method according to claim 7 or 8, wherein the vector transitions (VT) of the merged vector states (S0T0V0, S1T1V0) are adapted to vector transitions (VT) referring to the common state (S0T*V0) as follows:
i) in case that a vector transition (VT) refers to a vector transition from one merged vector state (S0T0V0, S1T1V0) to another merged vector state (S0T0V0, S0T1V0), a self-loop transition is generated from the common vector state (S0T*V0) to the common vector state (S0T*V0) having a new label (SL, SL') and the same trigger condition (SCO, SCO') as the vector transition from the merged vector state (S0T0V0, S0T1V0) to the other merged vector state (S0T0V0, S0T1V0);
ii) in case that there are several vector transitions (VT) from a non-merged vector state (VT) to different merged vector states (S0T0V0, S0T1V0), a single vector transition (VT) having a new label is generated, the trigger condition being an OR concatenation of the trigger conditions of the said several vector transitions (VT);
iii) in case that there are several vector transitions (VT) from different merged vector states to different non-merged vector states being referenced by the same label and trigger condition, each of said several vector transitions (VT) receives a different label (L', L") and a trigger condition (CO', CO") discriminating between different merged vector states (VT).

10. The method according to one of claims 7 to 9, wherein a validation step (VS3) is automatically performed after step f), where the validation step tests whether the third product automaton (PA") generates outputs corresponding to outputs of the simulation model (SM) when running a simulation of the technical component (CO) based on the simulation model (SM), where the method terminates in case of a successful validation and where otherwise the method provides an input option on a user interface (UI) enabling one or more user inputs (IN) to modify the third product automaton (PA"), whereupon step f) is repeated based on the modified second product automaton (PA").

11. An apparatus for computer-implemented generation of a state machine from a simulated technical component (CO) in a block-based simulation model (SM), where the simulated technical component (CO) is a block in the simulation model (SM) and comprises a plurality of variables (SP, TR, CU, VO, HF, TE), each variable (SP, TR, CU, VO, HF, TE) having a value range with variable values which can be assigned to the respective variable (SP, TR, CU, VO, HF, TE) when running a simulation of the technical component (CO) based on the simulation model (SM), where the apparatus is configured to perform a method comprising the following steps:
a) selecting one or more variables (SP, TR, VO) from the plurality of variables (SP, TR, CU, VO, HF, TE);
b) generating for each selected variable (SP, TR, VO) a plurality of discrete states (S0, S1, V0, V1, T0, T1), each state (S0, S1, V0, V1, T0, T1) comprising a subset of values from the value range of the respective selected variable (SP, TR, VO);
c) generating an automaton (A1, A2, A3) for each selected variable (SP, VO, TR), a respective automaton (A1, A2, A3) being represented by the states (S0, S1, V0, V1, T0, T1) of the respective selected variable (SP, TR, VO) and one or more transitions (TS1, TS2, ..., TS6) from one state to another state of the respective selected variable (SP, TR, VO), a respective transition (TS1, TS2, ..., TS6) being referenced by a label (L1, L2, ..., L6) and being associated with a trigger condition (CO1, CO2, ..., CO6) defining the change of the respective selected variable (SP, TR, VO) resulting in the respective transition (TS1, TS2, ..., TS6);
d) generating a first product automaton (PA) from the automatons (A1, A2, A3) of all selected variables (SP, TR, VO), the first product automaton (PA) comprising a plurality of vector states (S0T0P0, S1T0V0, ..., S1T1V1) representing all combinations of states (S0, S1, V0, V1, T0, T1) of the selected variables (SP, VO, TR) and a plurality of vector transitions (VT) for all transitions (TS1, TS2, ..., TS6) of single variables (SP, TR, CU, VO, HF, TE) generated in step c), each vector transition (VT) corresponding to a transition (TS1, TS2, ..., TS6) from one state to another state of a single variable (SP, VO, TR) in a respective vector state (S0T0P0, S1T0V0, ..., S1T1V1) where the states (S0, S1, V0, V1, T0, T1) of the other variables (SP, VO, TR) in the respective vector state (S0T0P0, S1T0V0, ..., S1T1V1) remain unchanged, where the label (L1, L2, ..., L6) and the trigger condition (CO1, CO2, ..., CO6) of the respective vector transition (VT) correspond to the label (LA1, LA2, ..., LA6) and the trigger condition (CO1, CO2, ..., CO6) of the transition (TS1, TS2, ..., TS6) to which the respective vector transition (VT) corresponds;
e) removing superfluous vector transitions (VT') from the first product automaton (PA) based on predefined rules (RU) applying to the simulation model (SM), the first product automaton (PA) not containing the removed superfluous vector transitions (VT') is a second product automaton (PA') which is the generated state machine wherein said first product automation (PA) is reduced in size such that less computational resources are needed when processing the second product automation.

12. The apparatus according to claim 11, wherein the apparatus is configured to perform a method according to one of claims 2 to 10.

13. A computer program product with program code, which is stored on a non-transitory machine-readable carrier, for carrying out a method according to one of claims 1 to 10 when the program code is executed on a computer.

14. A computer program with program code for carrying out a method according to one of claims 1 to 10 when the program code is executed on a computer.

## Patentansprüche

1. Verfahren zur computerimplementierten Generierung einer Zustandsmaschine aus einer simulierten technischen Komponente (CO) in einem blockbasierten Simulationsmodell (SM), wobei die simulierte technische Komponente (CO) ein Block im Simulationsmodell (SM) ist und durch eine Vielzahl von Variablen (SP, TR, CU, VO, HF, TE) gekennzeichnet ist, wobei jede Variable (SP, TR, CU, VO, HF, TE) einen Wertebereich mit Variablenwerten aufweist, die bei Durchführung einer Simulation der technischen Komponente (CO) basierend auf dem Simulationsmodell (SM) der jeweiligen Variablen (SP, TR, CU, VO, HF, TE) zuordenbar sind, wobei das Verfahren durch die folgenden Schritte gekennzeichnet ist:
a) Auswählen einer oder mehrerer Variablen (SP, TR, VO) aus der Vielzahl von Variablen (SP, TR, CU, VO, HF, TE);
b) Generieren einer Vielzahl von diskreten Zuständen (S0, S1, V0, V1, T0, T1) für jede ausgewählte Variable (SP, TR, VO), wobei jeder Zustand (S0, S1, V0, V1, T0, T1) eine Teilmenge von Werten aus dem Wertebereich der jeweiligen ausgewählten Variable (SP, TR, VO) umfasst;
c) Generieren eines Automaten (A1, A2, A3) für jede ausgewählte Variable (SP, VO, TR), wobei ein jeweiliger Automat (A1, A2, A3) durch die Zustände (S0, S1, V0, V1, T0, T1) der jeweiligen ausgewählten Variable (SP, TR, VO) und einen oder mehrere Übergänge (TS1, TS2, ... TS6) von einem Zustand zu einem anderen Zustand der jeweiligen ausgewählten Variable (SP, TR, VO) repräsentiert wird, wobei ein jeweiliger Übergang (TS1, TS2, ... TS6) durch ein Label (L1, L2, ... L6) referenziert wird und einer Triggerbedingung (CO1, CO2, ... CO6) zugeordnet ist, die Änderung der jeweiligen ausgewählten Variable (SP, TR, VO) definiert, die zu dem jeweiligen Übergang (TS1, TS2, ... TS6) führt;
d) Generieren eines ersten Produktautomaten (PA) aus den Automaten (A1, A2, A3) aller ausgewählten Variablen (SP, TR, VO), wobei der erste Produktautomat (PA) eine Vielzahl von Vektorzuständen (S0T0P0, S1T0V0, ... S1T1V1) umfasst, die alle Kombinationen von Zuständen (S0, S1, V0, V1, T0, T1) der ausgewählten Variablen (SP, VO, TR) repräsentieren, und eine Vielzahl von Vektorübergängen (VT) für alle Übergänge (TS1, TS2, ... TS6) einzelner Variablen (SP, TR, CU, VO, HF, TE), die in Schritt c) generiert wurden, wobei jeder Vektorübergang (VT) einem Übergang (TS1, TS2, ... TS6) von einem Zustand zu einem anderen Zustand einer einzelnen Variablen (SP, VO, TR) in einem jeweiligen Vektorzustand (S0T0P0, S1T0V0, ... S1T1V1) entspricht, wobei die Zustände (S0, S1, V0, V1, T0, T1) der anderen Variablen (SP, VO, TR) in dem jeweiligen Vektorzustand (S0T0P0, S1T0V0, ... S1T1V1) unverändert bleiben, wobei das Label (L1, L2, ... L6) und die Triggerbedingung (CO1, CO2, ... CO6) des jeweiligen Vektorübergangs (VT) dem Label (LA1, LA2, ... LA6) und der Triggerbedingung (CO1, CO2, ... CO6) des Übergangs (TS1, TS2, ... TS6) entsprechen, dem der jeweilige Vektorübergang (VT) entspricht;
e) Entfernen von überflüssigen Vektorübergängen (VT') aus dem ersten Produktautomaten (PA) basierend auf vordefinierten, auf das Simulationsmodell (SM) anwendbaren Regeln (RU), wobei der erste Produktautomat (PA), der die entfernten überflüssigen Vektorübergänge (VT') nicht enthält, ein zweiter Produktautomat (PA') ist, der die generierte Zustandsmaschine ist, wobei der erste Produktautomat (PA) derart verkleinert ist, dass bei der Bearbeitung des zweiten Produktautomaten weniger Rechenressourcen benötigt werden.

2. Verfahren nach Anspruch 1, wobei der Schritt a) mindestens teilweise automatisch basierend auf einer vordefinierten Auswahl von mindestens einer Variable (SP, TR, VO) durchgeführt wird und/oder wobei der Schritt a) mindestens teilweise halbautomatisch als Reaktion auf eine oder mehrere Benutzereingaben (IN) über eine Benutzerschnittstelle (UI) definiert wird, wobei die eine oder mehreren Benutzereingaben (IN) mindestens eine auszuwählende Variable (SP, TR, VO) spezifizieren.

3. Verfahren nach Anspruch 1 oder 2, wobei der Schritt b) mindestens teilweise automatisch basierend auf vordefinierten Teilmengen von Werten aus dem Wertebereich einer oder mehrerer ausgewählter Variablen (SP, TR, VO) durchgeführt wird und/oder wobei der Schritt b) mindestens teilweise halbautomatisch als Reaktion auf Benutzereingaben (IN) über eine Benutzerschnittstelle (UI) durchgeführt wird, die Teilmengen von Werten aus dem Wertebereich einer oder mehrerer ausgewählter Variablen (SP, TR, VO) spezifiziert.

4. Verfahren nach einem der vorhergehenden Ansprüche, wobei der Schritt c) mindestens teilweise automatisch für mindestens eine ausgewählte Variable durchgeführt wird, um einen Automaten (A1, A2, A3) für die mindestens eine ausgewählte Variable (SP, VO, TR) zu generieren, und/oder wobei der Schritt c) mindestens teilweise halbautomatisch als Reaktion auf eine oder mehrere Benutzereingaben (IN) über eine Benutzerschnittstelle (UI) für mindestens eine ausgewählte Variable (SP, TR, VO) durchgeführt wird, um einen Automaten (A1, A2, A3) für die mindestens eine ausgewählte Variable (SP, VO, TR) zu generieren, wobei die eine oder mehreren Benutzereingaben (IN) die Übergänge (TS1, TS2, ... TS6) der mindestens einen ausgewählten Variable (SP, TR, VO) spezifizieren.

5. Verfahren nach einem der vorhergehenden Ansprüche, wobei zwischen den Schritten d) und e) automatisch ein Validierungsschritt (VS1) durchgeführt wird, wobei der Validierungsschritt (VS1) prüft, ob der erste Produktautomat (PA) Ausgaben generiert, die den Ausgaben des Simulationsmodells (SM) entsprechen, wenn eine Simulation der technischen Komponente (CO) basierend auf dem Simulationsmodell (SM) ausgeführt wird, wobei das Verfahren im Falle einer erfolgreichen Validierung (VS1) mit Schritt e) fortfährt und andernfalls eine Eingabemöglichkeit auf einer Benutzeroberfläche (UI) bereitstellt, die eine oder mehrere Benutzereingaben (IN) ermöglicht, um den ersten Produktautomaten (PA) zu modifizieren, woraufhin Schritt d) basierend auf dem modifizierten ersten Produktautomaten (PA) wiederholt wird.

6. Verfahren nach einem der vorhergehenden Ansprüche, wobei nach Schritt e) automatisch ein Validierungsschritt (VS2) durchgeführt wird, wobei der Validierungsschritt (VS2) prüft, ob der zweite Produktautomat (PA') Ausgaben generiert, die Ausgaben des Simulationsmodells (SM) entsprechen, wenn eine Simulation der technischen Komponente (CO) basierend auf dem Simulationsmodell (SM) ausgeführt wird, wobei das Verfahren im Falle einer erfolgreichen Validierung abbricht oder mit einem anderen Schritt fortfährt, ohne eine manuelle Änderung des zweiten Produktautomaten (PA') zu ermöglichen, und wobei das Verfahren andernfalls eine Eingabemöglichkeit auf einer Benutzeroberfläche (UI) bereitstellt, die eine oder mehrere Benutzereingaben (IN) zur Änderung des zweiten Produktautomaten (PA') ermöglicht, woraufhin Schritt e) auf der Grundlage des geänderten zweiten Produktautomaten (PA') wiederholt wird.

7. Verfahren nach einem der vorhergehenden Ansprüche, wobei der zweite Produktautomat (PA') nach Schritt e) durch einen Schritt f), der einen oder mehrere Zusammenführungen umfasst, weiterverarbeitet wird, wobei in einer jeweiligen Zusammenführung mehrere Vektorzustände (S0T0V0, S0T1V0) des zweiten Produktautomaten (PA'), die sich im Wert einer einzelnen Variablen (SP, TR, CU, VO, HF, TE) unterscheiden, zu einem gemeinsamen Vektorzustand (S0T*V0) zusammengeführt werden, der die zusammengeführten Vektorzustände (S0T0V0, S0T1V0) ersetzt, wobei die Vektorübergänge (VT), die sich auf die zusammengeführten Vektorzustände (S0T0V0, S0T1V0) beziehen, an Vektorübergänge angepasst sind, die sich auf den gemeinsamen Vektorzustand beziehen, sodass ein dritter Produktautomat (PA") entsteht.

8. Verfahren nach Anspruch 7, wobei mindestens eine Zusammenführung automatisch basierend auf vordefinierten Regeln durchgeführt wird und/oder wobei mindestens eine Zusammenführung halbautomatisch als Reaktion auf eine oder mehrere Benutzereingaben (IN) über eine Benutzerschnittstelle (UI) durchgeführt wird, wobei die eine oder mehreren Benutzereingaben (IN) die Beschreibung der zusammenzuführenden Vektorzustände (S0T0V0, S1T1V0) spezifizieren.

9. Verfahren nach Anspruch 7 oder 8, wobei die Vektorübergänge (VT) der zusammengeführten Vektorzustände (S0T0V0, S1T1V0) an Vektorübergänge (VT) angepasst sind, die sich auf den gemeinsamen Zustand (S0T*V0) beziehen, wie folgt:
i) für den Fall, dass ein Vektorübergang (VT) einen Vektorübergang von einem zusammengeführten Vektorzustand (S0T0V0, S1T1V0) zu einem anderen zusammengeführten Vektorzustand (S0T0V0, S0T1V0) bezeichnet, wird ein Selbstschleifenübergang vom gemeinsamen Vektorzustand (S0T*V0) in den gemeinsamen Vektorzustand (S0T*V0) mit einem neuen Label (SL, SL') und der gleichen Triggerbedingung (SCO, SCO') generiert wie der Vektorübergang vom zusammengeführten Vektorzustand (S0T0V0, S0T1V0) in den anderen zusammengeführten Vektorzustand (S0T0V0, S0T1V0);
ii) falls mehrere Vektorübergänge (VT) von einem nicht zusammengeführten Vektorzustand (VT) zu verschiedenen zusammengeführten Vektorzuständen (S0T0V0, S0T1V0) vorliegen, wird ein einziger Vektorübergang (VT) mit einem neuen Label generiert, wobei die Triggerbedingung eine ODER Verkettung der Triggerbedingungen der genannten mehreren Vektorübergänge (VT) ist;
iii) für den Fall, dass mehrere Vektorübergänge (VT) von verschiedenen zusammengeführten Vektorzuständen zu verschiedenen nicht zusammengeführten Vektorzuständen vorliegen, auf die mit demselben Label und derselben Triggerbedingung Bezug genommen wird, erhält jeder der mehreren Vektorübergänge (VT) ein unterschiedliches Label (L', L") und eine Triggerbedingung (CO', CO"), die zwischen verschiedenen zusammengeführten Vektorzuständen (VT) unterscheidet.

10. Verfahren nach einem der Ansprüche 7 bis 9, wobei nach Schritt f) automatisch ein Validierungsschritt (VS3) durchgeführt wird, wobei der Validierungsschritt prüft, ob der dritte Produktautomat (PA") Ausgaben generiert, die Ausgaben des Simulationsmodells (SM) entsprechen, wenn eine Simulation der technischen Komponente (CO) basierend auf dem Simulationsmodell (SM) ausgeführt wird, wobei das Verfahren im Falle einer erfolgreichen Validierung beendet wird und wobei das Verfahren andernfalls eine Eingabemöglichkeit auf einer Benutzeroberfläche (UI) bereitstellt, die eine oder mehrere Benutzereingaben (IN) ermöglicht, um den dritten Produktautomaten (PA") zu modifizieren, woraufhin Schritt f) auf der Grundlage des modifizierten zweiten Produktautomaten (PA") wiederholt wird.

11. Vorrichtung zur computerimplementierten Generierung einer Zustandsmaschine aus einer simulierten technischen Komponente (CO) in einem blockbasierten Simulationsmodell (SM), wobei die simulierte technische Komponente (CO) ein Block im Simulationsmodell (SM) ist und eine Vielzahl von Variablen (SP, TR, CU, VO, HF, TE) umfasst, wobei jede Variable (SP, TR, CU, VO, HF, TE) einen Wertebereich mit Variablenwerten aufweist, die bei Durchführung einer Simulation der technischen Komponente (CO) basierend auf dem Simulationsmodell (SM) der jeweiligen Variablen (SP, TR, CU, VO, HF, TE) zuordenbar sind, wobei die Vorrichtung so konfiguriert ist, dass sie ein Verfahren durchführt, das die folgenden Schritte umfasst:
a) Auswählen einer oder mehrerer Variablen (SP, TR, VO) aus der Vielzahl von Variablen (SP, TR, CU, VO, HF, TE);
b) Generieren einer Vielzahl von diskreten Zuständen (S0, S1, V0, V1, T0, T1) für jede ausgewählte Variable (SP, TR, VO), wobei jeder Zustand (S0, S1, V0, V1, T0, T1) eine Teilmenge von Werten aus dem Wertebereich der jeweiligen ausgewählten Variable (SP, TR, VO) umfasst;
c) Generieren eines Automaten (A1, A2, A3) für jede ausgewählte Variable (SP, VO, TR), wobei ein jeweiliger Automat (A1, A2, A3) durch die Zustände (S0, S1, V0, V1, T0, T1) der jeweiligen ausgewählten Variable (SP, TR, VO) und einen oder mehrere Übergänge (TS1, TS2, ... TS6) von einem Zustand zu einem anderen Zustand der jeweiligen ausgewählten Variable (SP, TR, VO) repräsentiert wird, wobei ein jeweiliger Übergang (TS1, TS2, ... TS6) durch ein Label (L1, L2, ... L6) referenziert wird und einer Triggerbedingung (CO1, CO2, ... CO6) zugeordnet ist, die die Änderung der jeweiligen ausgewählten Variable (SP, TR, VO) definiert, die zu dem jeweiligen Übergang (TS1, TS2, ... TS6) führt;
d) Generieren eines ersten Produktautomaten (PA) aus den Automaten (A1, A2, A3) aller ausgewählten Variablen (SP, TR, VO), wobei der erste Produktautomat (PA) eine Vielzahl von Vektorzuständen (S0T0P0, S1T0V0, ... S1T1V1) umfasst, die alle Kombinationen von Zuständen (S0, S1, V0, V1, T0, T1) der ausgewählten Variablen (SP, VO, TR) repräsentieren, und eine Vielzahl von Vektorübergängen (VT) für alle Übergänge (TS1, TS2, ... TS6) von einzelnen Variablen (SP, TR, CU, VO, HF, TE) in Schritt c generiert, wobei jeder Vektorübergang (VT) einem Übergang (TS1, TS2, **...** TS6) von einem Zustand in einen anderen Zustand einer einzelnen Variablen (SP, VO, TR) in einem jeweiligen Vektorzustand (S0T0P0, S1T0V0, ... S1T1V1) entspricht, wobei die Zustände (S0, S1, V0, V1, T0, T1) der anderen Variablen (SP, VO, TR) in dem jeweiligen Vektorzustand (S0T0P0, S1T0V0, ... S1T1V1) unverändert bleiben, wobei das Label (L1, L2, ... L6) und die Triggerbedingung (CO1, CO2, ... CO6) des jeweiligen Vektorübergangs (VT) dem Label (LA1, LA2, **...** LA6) und der Triggerbedingung (CO1, CO2, **...** CO6) des Übergangs (TS1, TS2, **...** TS6), dem der jeweilige Vektorübergang (VT) entspricht, entsprechen;
e) Entfernen von überflüssigen Vektorübergängen (VT') aus dem ersten Produktautomaten (PA) basierend auf vordefinierten, auf das Simulationsmodell (SM) anwendbaren Regeln (RU), wobei der erste Produktautomat (PA), der die entfernten überflüssigen Vektorübergänge (VT') nicht enthält, ein zweiter Produktautomat (PA') ist, der die generierte Zustandsmaschine ist, wobei der erste Produktautomat (PA) derart verkleinert ist, dass weniger Rechenressourcen bei der Verarbeitung des zweiten Produktautomaten benötigt werden.

12. Vorrichtung nach Anspruch 11, wobei die Vorrichtung so konfiguriert ist, dass sie ein Verfahren nach einem der Patentansprüche 2 bis 10 ausführt.

13. Computerprogrammprodukt mit Programmcode, der auf einem nicht übertragbaren maschinenlesbaren Träger gespeichert ist, zur Durchführung eines Verfahrens nach einem der Patentansprüche 1 bis 10, wenn der Programmcode auf einem Computer ausgeführt wird.

14. Computerprogramm mit Programmcode zur Ausführung eines Verfahrens nach einem der Patentansprüche 1 bis 10, wenn der Programmcode auf einem Computer ausgeführt wird.

## Revendications

1. Un procédé de création, mis en œuvre par ordinateur, d'un automate fini à partir d'un composant (CO) technique simulé dans un modèle (SM) de simulation à base de blocs, dans lequel le composant (CO) technique simulé est un bloc dans le modèle (SM) de simulation et comprend une pluralité de variables (SP, TR, CU, VO, HF, TE), chaque variable (SP, TR, CU, VO, HF, TE) ayant une plage de valeurs avec des valeurs variables, qui peuvent être affectées à la variable (SP, TR, CU, VO, HF, TE) respective, lorsqu'on effectue une simulation du composant (CO) technique sur la base du modèle (SM) de simulation, le procédé comprenant les stades suivants :
a) sélectionner une ou plusieurs variables (SP, TR, VO) parmi la pluralité de variables (SP, TR, CU, VO, HF, TE) ;
b) créer, pour chaque variable (SP, TR, VO) sélectionnée, une pluralité d'états (S0, S1, VO, V1, T0, T1) discrets, chaque état (S0, S1, VO, V1, T0, T1) comprenant un sous-ensemble de valeurs parmi la plage de valeurs de la variable (SP, TR, VO) sélectionnée respective ;
c) créer un automaton (A1, A2, A3) pour chaque variable (SP, VO, TR) sélectionnée, un automaton (A1, A2, A3) respectif étant représenté par les états (S0, S1, VO, V1, T0, T1) de la variable (SP, TR, VO) sélectionnée respective et par une ou plusieurs transitions (TS1, TS2, **...,** TS6) d'un état à un autre état de la variable (SP, TR, VO) sélectionnée respective, une transition (TS1, TS2, **...,** TS6) respective étant référencée par une étiquette (L1, L2, ..., L6) et étant associée à une condition (CO1, CO2, **...,** CO6) de déclenchement définissant le changement de la variable (SP, TR, VO) sélectionnée respective se traduisant en la transition (TS1, TS2, ..., TS6) respective ;
d) créer un premier automaton (PA) de produit à partir des automatons (A1, A2, A3) de toutes les variables (SP, TR, VO) sélectionnées, le premier automaton (PA) de produit comprenant une pluralité d'états (S0T0P0, S1T0V0, ..., S1T1V1) vectoriels représentant toutes les combinaisons d'états (S0, S1, V0, V1, T0, T1) des variables (SP, VO, TR) sélectionnées et une pluralité de transitions (VT) vectorielles pour toutes les transitions (TS1, TS2, ..., TS6) de variables (SP, TR, CU, VO, HF, TE) individuelles créées dans le stade c), chaque transition (VT) vectorielle correspondant à une transition (TS1, TS2, ..., TS6) d'un état à un autre état d'une variable (SP, VO, TR) individuelle dans un état (S0T0P0, S1T0V0, ..., S1T1V1) vectoriel respectif, dans lequel les états (S0, S1, VO, V1, T0, T1) des autres variables (SP, VO, TR) dans l'état (S0T0P0, S1T0V0, **...** S1T1V1) vectoriel respectif restent inchangés, dans lequel l'étiquette (L1, L2, ..., L6) et la condition (CO1, CO2, ..., CO6) de déclenchement de la transition (VT) vectorielle respective correspondent à l'étiquette (LA1, LA2, ..., LA6) et à la condition (CO1, CO2, ..., CO6) de déclenchement de la transition (TS1, TS2, **...** TS6) à laquelle la transition (VT) vectorielle respective correspond ;
e) retirer des transitions (VT') vectorielles superflues du premier automaton (PA) de produit sur la base de règles (RU) définies à l'avance s'appliquant au modèle (SM) de simulation, le premier automaton (PA) de produit ne contenant pas les transitions (VT') vectorielles superflues retirées est un deuxième automaton (PA') de produit, qui est l'automate fini créé,
dans lequel ledit premier automaton (PA) de produit est réduit en dimension, de manière à ce que moins de ressources informatiques soient nécessaires lors du traitement du deuxième automaton de produit.

2. Le procédé suivant la revendication 1, dans lequel le stade a) est effectué au moins en partie automatiquement sur la base d'une sélection définie à l'avance d'au moins une variable (SP, TR, VO), et/ou dans lequel le stade a) est effectué au moins en partie semi-automatiquement en réaction à une ou à plusieurs entrées (IN) d'utilisateur par l'intermédiaire d'une interface (UI) d'utilisateur, la une ou les plusieurs entrées (IN) d'utilisateur précisant au moins une variable (SP, TR, VO), qui doit être sélectionnée.

3. Le procédé suivant la revendication 1 ou 2, dans lequel le stade b) est effectué au moins en partie automatiquement sur la base de sous-ensembles définis à l'avance de valeurs parmi la plage de valeurs d'une ou de plusieurs variables (SP, TR, VO) sélectionnées, et/ou dans lequel le stade b) est effectué au moins en partie semi-automatiquement en réaction à des entrées (IN) d'utilisateur par l'intermédiaire d'une interface (UI) d'utilisateur définissant des sous-ensembles de valeurs parmi la plage de valeurs d'une ou de plusieurs variables (SP, TR, VO) sélectionnées.

4. Le procédé suivant l'une des revendications précédentes, dans lequel le stade c) est effectué au moins en partie automatiquement pour au moins une variable sélectionnée, afin de créer un automaton (A1, A2, A3) pour la au moins une variable (SP, VO, TR) sélectionnée, et/ou dans lequel le stade c) est effectué au moins en partie semi-automatiquement en réaction à une ou à plusieurs entrées (IN) d'utilisateur par l'intermédiaire d'une interface (UI) d'utilisateur pour au moins une variable (SP, TR, VO) sélectionnée afin de créer un automaton (A1, A2, A3) pour la au moins une variable (SP, VO, TR) sélectionnée, la une ou les plusieurs entrées (IN) d'utilisateur précisant les transitions (TS1, TS2, **...,** TS6) de la au moins une variable (SP, TR, VO) sélectionnée.

5. Le procédé suivant l'une des revendications précédentes, dans lequel un stade (VS1) de validation est effectué automatiquement entre les stades d) et e), dans lequel le stade (VS1) de validation teste si le premier automaton (PA) de produit crée des sorties correspondant à des sorties du modèle (SM) de simulation lorsqu'une simulation du composant (CO) technique est effectué sur la base du modèle (SM) de simulation, dans lequel le procédé se poursuit par un stade e) dans le cas d'une validation (VS1) réussie, et dans lequel sinon le procédé donne une option d'entrée sur une interface (UI) d'utilisateur en permettant à une ou à plusieurs entrées (IN) d'utilisateur de modifier le premier automaton (PA) de produit, après quoi le stade d) est répété sur la base du premier automaton (PA) de produit modifié.

6. Le procédé suivant l'une des revendications précédentes, dans lequel un stade (VS2) de validation est effectué automatiquement après le stade e), dans lequel le stade (VS2) de validation teste si le deuxième automaton (PA') de produit crée des sorties correspondant à des sorties du modèle (SM) de simulation lorsqu'une simulation du composant (CO) technique est effectuée sur la base du modèle (SM) de simulation, dans lequel le procédé prend fin ou se poursuit par un autre stade sans permettre une modification manuelle du deuxième automaton (PA') de produit dans le cas d'une validation réussie, et dans lequel sinon le procédé donne une option d'entrée sur une interface (UI) d'utilisateur permettant à une ou à plusieurs entrées (IN) d'utilisateur de modifier le deuxième automaton (PA') de produit, puis le stade e) est répété sur la base du deuxième automaton (PA') de produit modifié.

7. Le procédé suivant l'une des revendications précédentes, dans lequel le deuxième automaton (PA') de produit est traité davantage après le stade e) par un stade f) comprenant une ou plusieurs opérations de fusion, dans lequel dans une opération de fusion respective plusieurs états (S0T0V0, S0T1V0) vectoriels du deuxième automaton (PA') de produit, différents par la valeur d'une variable (SP, TR, CU, VO, HF, TE) individuelle sont fusionnés en un état (S0T*V0) vectoriel commun remplaçant les états (S0T0V0, SOT1V0) vectoriels fusionnés, les transitions (VT) vectorielles se référant aux états (S0T0V0, SOT1VO) vectoriels fusionnés étant adaptés à des transitions vectorielles se référant à l'état vectoriel commun, ce qui donne un troisième automaton (PA") de produit.

8. Le procédé suivant la revendication 7, dans lequel une opération de fusion est effectuée automatiquement sur la base de règles définies à l'avance, et/ou dans lequel au moins une opération de fusion est effectuée semi-automatiquement en réaction à une ou plusieurs entrées (IN) d'utilisateur par l'intermédiaire d'une interface (UI) d'utilisateur, la une ou les plusieurs entrées (IN) d'utilisateur précisant les états (S0T0V0, S1T1V0) vectoriels à fusionner.

9. Le procédé suivant la revendication 7 ou 8, dans lequel les transitions (VT) vectorielles des états (S0T0V0, S1T1V0) vectoriels fusionnés sont adaptés à des transitions (VT) vectorielles se référant à l'état (S0T*V0) commun de la manière suivante :
i) dans le cas où une transition (VT) vectorielle se réfère à une transition vectorielle d'un état (S0T0V0, S1T1V0) vectoriel fusionné à un autre état (S0T0V0, S0T1V0) vectoriel fusionné, une transition d'auto-boucle est créée de l'état (S0T*V0) vectoriel commun à l'état (S0T*V0) vectoriel ayant une nouvelle étiquette (SL, SL') et la même condition (SCO, SCO') de déclenchement que la transition vectorielle de l'état (S0T0V0, SOT1VO) vectoriel fusionné à l'autre état (S0T0V0, SOT1VO) vectoriel fusionné ;
ii) dans le cas où il y a plusieurs transitions (VT) vectorielles d'un état (VT) vectoriel non fusionné à des états (S0T0V0, SOT1VO) vectoriels fusionnés différents, une transition (VT) vectorielle individuelle ayant une nouvelle étiquette est créée, la condition de déclenchement étant une concaténation OU des conditions de déclenchement desdites plusieurs transitions (VT) vectorielles ;
iii) dans le cas où il y a plusieurs transitions (VT) vectorielles de différents états vectoriels fusionnés à des différents états vectoriels non fusionnés référencés par la même étiquette et condition de déclenchement, chacune desdites plusieurs transitions (VT) vectorielles reçoit une étiquette (L', L'') différente et une condition (C0', CO") de déclenchement différente discriminant entre des états (VT) vectoriels fusionnés différents.

10. Le procédé suivant l'une des revendications 7 à 9, dans lequel un stade (VS3) de validation est effectué automatiquement après le stade f), dans lequel le stade de validation teste si le troisième automaton (PA") de produit crée des sorties correspondant à des sorties du modèle (SM) de simulation lorsqu'une simulation du composant (CO) technique est effectuée sur la base du modèle (SM) de simulation, dans lequel le procédé prend fin dans le cas d'une validation réussie et dans lequel sinon le procédé donne une option d'entrée sur une interface (UI) d'utilisateur en permettant à une ou à plusieurs entrées (IN) d'utilisateur de modifier le troisième automaton (PA") de produit, puis le stade f) est répété sur la base du deuxième automaton (PA") de produit modifié.

11. Une installation de création, mise en œuvre par ordinateur, d'un automate fini, à partir d'un composant (CO) technique simulé dans un modèle (SM) de simulation à base de blocs,
dans lequel le composant (CO) technique simulé est un bloc dans le modèle (SM) de simulation et comprend une pluralité de variables (SP, TR, CU, VO, HF, TE), chaque variable (SP, TR, CU, VO, HF, TE) ayant une plage de valeurs avec des valeurs variables, qui peuvent être affectées à la variable (SP, TR, CU, VO, HF, TE) respective, lorsqu'on effectue une simulation du composant (CO) technique sur la base du modèle (SM) de simulation, l'installation est configurée pour effectuer un procédé comprenant les stades :
a) sélectionner une ou plusieurs variables (SP, TR, VO) parmi la pluralité de variables (SP, TR, CU, VO, HF, TE) ;
b) créer, pour chaque variable (SP, TR, VO) sélectionnée, une pluralité d'états (S0, S1, VO, V1, T0, T1) discrets, chaque état (S0, S1, VO, V1, T0, T1) comprenant un sous-ensemble de valeurs parmi la plage de valeurs de la variable (SP, TR, VO) sélectionnée respective ;
c) créer un automaton (A1, A2, A3) pour chaque variable (SP, VO, TR) sélectionnée, un automaton (A1, A2, A3) respectif étant représenté par les états (S0, S1, VO, V1, T0, T1) de la variable (SP, TR, VO) sélectionnée respective et par une ou plusieurs transitions (TS1, TS2, **...,** TS6) d'un état à un autre état de la variable (SP, TR, VO) sélectionnée respective, une transition (TS1, TS2, **...,** TS6) respective étant référencée par une étiquette (L1, L2, ..., L6) et étant associée à une condition (CO1, CO2, **...,** CO6) de déclenchement définissant le changement de la variable (SP, TR, VO) sélectionnée respective se traduisant en la transition (TS1, TS2, **...,** TS6) respective ;
d) créer un premier automaton (PA) de produit à partir des automatons (A1, A2, A3) de toutes les variables (SP, TR, VO) sélectionnées, le premier automaton (PA) de produit comprenant une pluralité d'états (S0T0P0, S1T0V0, **...,** S1T1V1) vectoriels représentant toutes les combinaisons d'états (S0, S1, VO, V1, T0, T1) des variables (SP, VO, TR) sélectionnées et une pluralité de transitions (VT) vectorielles pour toutes les transitions (TS1, TS2, **...,** TS6) de variables (SP, TR, CU, VO, HF, TE) individuelles créées dans le stade c), chaque transition (VT) vectorielle correspondant à une transition (TS1, TS2, **...,** TS6) d'un état à un autre état d'une variable (SP, VO, TR) individuelle dans un état (S0T0P0, S1T0V0, **...,** S1T1V1) vectoriel respectif, dans lequel les états (S0, S1, VO, V1, T0, T1) des autres variables (SP, VO, TR) dans l'état (S0T0P0, S1T0V0, **...** S1T1V1) vectoriel respectif restent inchangés, dans lequel l'étiquette (L1, L2, **...,** L6) et la condition (CO1, CO2, ..., CO6) de déclenchement de la transition (VT) vectorielle respective correspondent à l'étiquette (LA1, LA2, **...,** LA6) et à la condition (CO1, CO2, ..., CO6) de déclenchement de la transition (TS1, TS2, **...** TS6) à laquelle la transition (VT) vectorielle respective correspond ;
e) retirer des transitions (VT') vectorielles superflues du premier automaton (PA) de produit sur la base de règles (RU) définies à l'avance s'appliquant au modèle (SM) de simulation, le premier automaton (PA) de produit ne contenant pas les transitions (VT') vectorielles superflues retirées est un deuxième automaton (PA') de produit, qui est l'automate fini créé,
dans laquelle ledit premier automaton (PA) de produit est réduit en dimension, de manière à ce que moins de ressources informatiques soient nécessaires lors du traitement du deuxième automaton de produit.

12. L'installation suivant la revendication 11, dans laquelle l'installation est configurée pour effectuer un procédé suivant l'une des revendications 2 à 10.

13. Un produit de programme d'ordinateur ayant un code de programme, qui est mis en mémoire sur un support non transitoire déchiffrable par machine, pour effectuer un procédé suivant l'une des revendications 1 à 10, lorsque le code de programme est exécuté sur un ordinateur.

14. Un programme d'ordinateur ayant un code de programme pour effectuer un procédé suivant l'une des revendications 1 à 10, lorsque le code de programme est exécuté sur un ordinateur.
